Europäisches Patentamt

European Patent Office

Office européen des brevets

(11) Publication number: **0 175 378 B1**

# EUROPEAN PATENT SPECIFICATION

(45) Date of publication of patent specification: **21.11.91**   (51) Int. Cl.5: **H01L 27/10, G11C 11/24**

(21) Application number: **85111909.9**

(22) Date of filing: **20.09.85**

(54) Dynamic random access memory (DRAM).

(30) Priority: **21.09.84 JP 198840/84**

(43) Date of publication of application:
**26.03.86 Bulletin 86/13**

(45) Publication of the grant of the patent:
**21.11.91 Bulletin 91/47**

(84) Designated Contracting States:
**DE FR GB**

(56) References cited:
**EP-A- 0 117 339**
**EP-A- 0 147 151**
**US-A- 3 868 654**
**US-A- 4 084 108**

**JAPANESE JOURNAL OF APPLIED PHYSICS,
Supplements, 16th Int. Conf. Solid State De-
vices and Materials, Tokyo, 30th September -
1st October 1984, pages 265-268, Tokyo, JP;
H.SHICHIJO et al.: "TITE RAM : a new SOI
DRAM gain cell for Mbit DRAM's"**

(73) Proprietor: **FUJITSU LIMITED**
**1015, Kamikodanaka Nakahara-ku**
**Kawasaki-shi Kanagawa 211(JP)**

(72) Inventor: **Nakano, Motoo c/o Fujitsu Limited**
**Patent Dept 1015 Kamikodanaka Nakahara-ku**
**Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

**Description**

The present invention relates to dynamic random access memory (hereafter DRAM) devices.

Random access memory (RAM) devices made using metaloxide-transistor (MOS) technology have been used widely in storage apparatuses of electronic devices such as computers. For RAM devices, there have been used two different techniques for storing information: namely there have been provided static MOS RAMs and dynamic MOS RAMs. A static MOS memory (RAM) usually has a relatively high speed of operation and a rather higher power dissipation as compared with a dynamic memory circuit (RAM). On the other hand, a dynamic MOS RAM (DRAM) need occupy less area on a substrate, being suitable for achieving high packing density, and has lesser power consumption, although its speed of operation is rather lower and more elaborate control circuits are required in comparison with a static RAM. DRAMs are increasingly used as storage devices of high capacity for electronic devices.

A great deal of effort has been made towards increasing the high packing density of DRAMS, resulting in reduction of the number of transistors per DRAM memory cell. Ultimately, a DRAM cell having only a single transistor has been developed and widely used. Such a one transistor memory cell requires only two control lines, a bit line and a word line. However, it requires a sensitive sense amplifier, because an output signal of the cell is read out as a potential differential of the associated bit line provided by a stored charge in a capacitor of the cell. When the cell is read out, a greater part of the electrical charge stored in the cell is consumed to charge up the parasitic capacity of the bit line, which means that only a small potential differential can be attained: namely a very faint output signal. Moreover, there is a tendency for the capacity of such a memory cell to be decreased, and for the parasitic capacity of the relevant data bit line to remain almost unchanged, as the packing density of the DRAM is increased. Thus, high sensitivity is increasingly required for the associated sense-amplifier, causing cost increase and reduction of packing density of a DRAM device.

There have been proposed other types of DRAM cells, intended to overcome the above-described disadvantages of a one-transistor cell. A three-transistor cell is one DRAM cell type recently proposed.

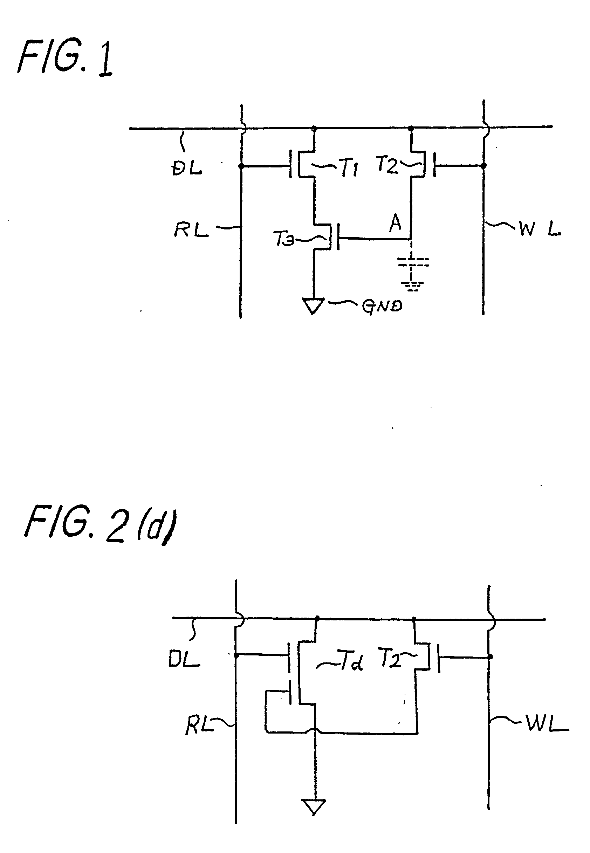

Fig. 1 is a schematic diagram of a previously proposed three-transistor memory cell, having a shared read/write (R/W) data bit line DL. The cell also has a read select line RL and a separate write select line WL. In a cell of this type, information is stored as the potential level of the gate of a storage

transistor $T_3$, which is generated in dependence upon stored charges in the gate electrode, and the stored information is output by making a read select transistor $T_1$ conductive, for example so as to discharge the data bit line DL to ground potential when the storage transistor $T_3$ is also conductive. Thus, an output signal potential differential (the difference between the voltage levels of the data bit line DL for different stored information values) can be substantially greater than the output signal potential differential available with a one-transistor cell. Thus, a simple sense-amplifier is sufficient to detect the output signal, which means that the sense-amplifier region can be reduced in size, providing a higher packing density in this respect. However, with a three transistor cell, the numbers of transistors and lines used for a cell are larger than those used for a one-transistor cell. When these elements and lines are arranged in a plane, the cell occupies a relatively large area, adversely affecting the packing density of a device using such cells.

EP-A-0 147 151, published on 03.07.85, claiming priority from Japanese Patent Application JP 237776/83 dated 19.12.83, discloses a three-transistor dynamic random access memory which has a structure in which a write address transistor is stacked on a read address transistor.

US-A-4 084 108 discloses (Fig. 3B) what appears to be a form of dual gate MOS transistor.

US-A-3 868 654 discloses the use of a common read/write select line with transistors of different threshold voltages.

According to the present invention there is provided a three-transistor cell for a dynamic random access memory formed on a semiconductor substrate, the cell comprising

a read select transistor, having a drain connected to a data bit line of the memory, and a gate connected to a read select line of the memory,

a storage transistor, having a drain connected to a source of the read select transistor and a source connected to a ground line of the memory, and

a write select transistor, having a source connected to a gate of the storage transistor, a gate connected to a write select line of the memory, and a drain connected to the data bit line,

characterised in that

the read select transistor and the storage transistor are formed as a dual gate transistor, a channel region of the read select transistor being directly connected to a channel region of the storage transistor to provide a channel region of the dual gate transistor, the channel region of the read select transistor also acting as drain of the storage transistor and the channel region of the storage transistor also acting as source of the read select transistor, the drain of the read select transistor being the drain of the dual gate transistor and the source of the storage transistor being the source of the dual gate transistor, between which drain and source the channel region of the dual gate transistor lies, and the two gates of the dual gate transistor being, respectively, the gate of the read select transistor and the gate of the storage transistor, which gates overlie the channel region of the dual gate transistor via an interposed insulator layer,

and characterised in that

the write select transistor is formed over the read select transistor, with an interposed insulator layer, the drain of the write select transistor being connected directly to the drain of the read select transistor through a window or opening in the latter interposed insulator layer,

and in that

the source region of the write select transistor acts also as the gate of the storage transistor which is otherwise provided on the same side of the latter interposed insulator layer as the read select transistor.

An embodiment of the present invention can provide a three-transistor cell for a DRAM having a structure enabling a higher packaging density to be achieved for the DRAM device.

An embodiment of the present invention can provide a three-transistor cell for a DRAM with a two-storied structure wherein an arrangement of elements and associated control lines of the cell is provided which is effective to reduce the area of the cell.

An embodiment of the present invention can provide a configuration for a three-transistor cell of a DRAM device which enables a reduction of the number of control lines from three to two (not including a ground line).

An embodiment of the present invention provides a structure for a cell of a DRAM device wherein electrical elements are arranged in a two-storied configuration such that a high packing density can be realized.

Embodiments of the present invention provide such two-storied structures of three transistor cells of DRAMS whereby the cells have either three or two driving lines besides a ground line.

In the above description of the previously proposed three-transistor memory cell shown in Fig. 1, it should be noted that transistor $T_1$ and transistor $T_3$ are both conductive when reading a stored signal "O", passing a current through the $T_1$-$T_3$ circuit between data bit line DL and ground line GND, but that transistor $T_1$ is conductive and transistor $T_3$ is non-conductive when a stored signal "1" is read and in this case no current flows through the $T_1$-$T_3$ circuit.

The inventor has appreciated that a dual gate field effect transistor can be applied in the cell of Fig. 1, by which the connection between transistor $T_1$ and transistor $T_3$ through respective source-drain regions can be omitted, serving to effect an economy as regards space on the relevant substrate of a DRAM device. This is applied in (some) embodiments of the present invention.

For saving area on a substrate of a semiconductor device, two-storied or two-level structures have been utilized, wherein electronic elements are arranged in two layers separated from one another by an insulator layer.

In an embodiment of the present invention, a read select transistor $T_1$, a storage transistor $T_3$, and a read select line RL which acts as a gate electrode of transistor $T_1$ are formed directly on the surface of a silicon substrate, i.e. on a first storey or level, whilst a write select transistor $T_2$ and a write (word) select line WL which acts as a gate of transistor $T_2$ are formed on a second storey, on an insulator layer separating the first and second stories. A data bit line DL is formed on a phosphosilicate glass layer covering the entire substrate.

In a DRAM memory cell in accordance with an embodiment of the present invention, the arrangement of the transistors is such that the write select transistor $T_2$ overlies the read select transistor $T_1$, and a common channel region is formed partially overlaid by the gates of read select transistor $T_1$ and storage transistor $T_3$. Thus the transistors $T_1$ and $T_3$ act like a dual gate transistor. As a result, in respect of the connecting portion between the two transistors, usually including at least source-drain regions, a remarkable saving is made. In addition, due to the overlying structure of transistor $T_2$ on transistor $T_1$ and the circuit configuration of the cell, one of the source-drain regions of transistor $T_2$ is utilized also as the gate electrode of transistor $T_3$, serving to save space on the substrate.

Furthermore, in accordance with an embodiment of the present invention, a circuit configuration of a DRAM cell is provided wherein the number of control lines of a memory cell is reduced from three to two; namely, a shared write/read bit line and a shared write/read select line, and two cell transistors having different threshold voltages from each other are used. A DRAM cell having a further simplified two-storied structure is provided in accordance with the circuit configuration of the cell.

Reference is made, by way of example, to the accompanying drawings, in which:-

Fig. 1 is a schematic circuit diagram of a previously proposed three transistor DRAM cell;

Fig. 2 (a) is a schematic circuit diagram of a three-transistor DRAM cell in accordance with a first embodiment of the present invention;

Fig. 2 (b) is a partial plan view illustrating the structure of the three transistor cell of Fig. 2 (a);

Fig. 2 (c) is a cross-sectional view of the cell of Fig. 2 (b), taken along the line A-A in Fig. 2 (b), illustrating the two-storey or two-level structure of the cell;

Fig. 2 (d) is a schematic circuit diagram, equivalent to that of Fig. 2 (a), introducing the concept of a dual gate field effect transistor;

Fig. 3 (a) is a schematic circuit diagram of a three-transistor DRAM cell in accordance with a second embodiment of the present invention, having a reduced number of driving lines as compared with the cell of Fig. 2 (a);

Fig. 3 (b) is a partial plan view illustrating the structure of the three transistor cell of Fig. 3 (a);

Fig. 3 (c) is a cross-sectional view of the three transistor cell of Fig. 3 (b), taken along the line A-A in Fig. 3 (b), illustrating the two-storey structure of the cell;

Fig. 4 is a plan view of a cell in accordance with the first embodiment of the present invention illustrating the location of the cross-sectional views given in Fig. 5 (a) to Fig. 5 (e); and

Figs. 5 (a) to 5 (e) are respective cross-sectional views relating to the cell of Fig. 4, taken along the line A-A shown in the plan view of Fig. 4, illustrating in sequence fabrication steps in the manufacture of a cell in accordance with the first embodiment of the present invention;

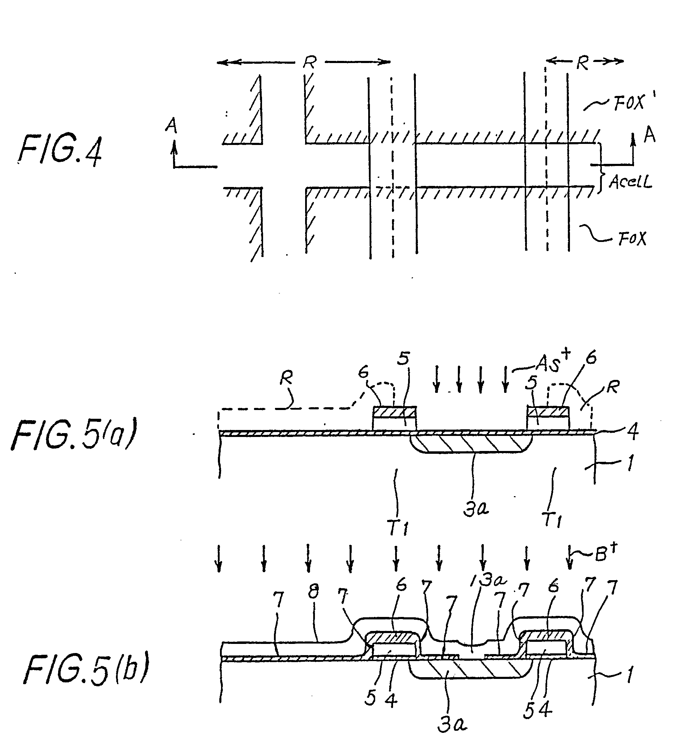

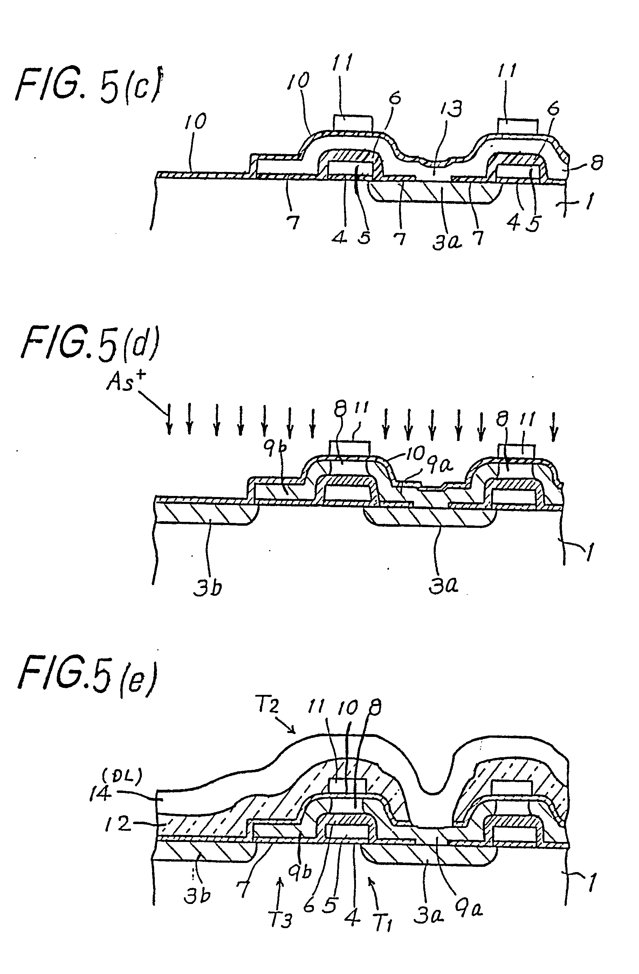

Fig. 5 (a) illustrates formation of a gate electrode and a diffusion region;

Fig. 5 (b) illustrates p-type doping of a SOI layer covering a substrate;

Fig. 5 (c) illustrates formation of a further gate electrode;

Fig. 5 (d) illustrates a n-type ion-implantation process for forming a diffused region; and

Fig. 5 (e) illustrates the cell after formation of a data bit line.

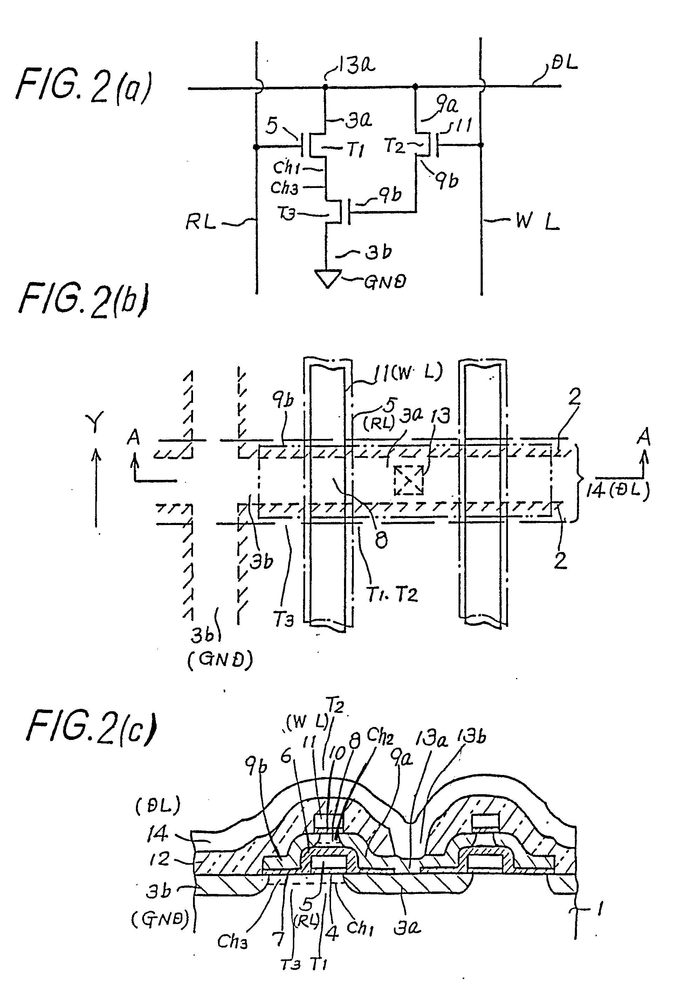

Referring to Figs. 2 (a) to 2 (c), there is shown a memory cell in accordance with a first embodiment of the present invention. Fig. 2 (a) is a circuit diagram of a memory cell of a DRAM; having three transistors and three control lines, whose configuration is quite similar to that of a previously proposed three transistor cell as shown in Fig. 1, except in relation to reference signs or indications Ch1, Ch3 denoting channel regions and in relation to reference signs or indications 3a, 3b, 9a and 9b denoting source-drain regions of respective transistors. These indications respectively correspond to those illustrated in the plan view of Fig. 2 (b) and the cross-sectional view of Fig. 2 (c).

On a p-type silicon substrate 1, field oxide layers 2, shown in the plan view of Fig. 2 (b) by hatching, are formed defining transistor regions and ground lines therebetween. In the substrate 1, a n+ type drain region 3a and a n+ type source region 3b are formed, having a channel region Ch1 plus Ch3 therebetween. A MOS transistor $T_1$, namely a read select transistor, comprises the drain region 3a, channel region Ch1, channel region Ch3 as its source region, a channel (gate) insulator layer 4 of silicon dioxide ($SiO_2$) approximately 300 Å (1Å = 0.1 nm) thick formed over the channel region Ch1, and a gate electrode 5 made of tungsten-silicide ($WSi_2$) or polycrystalline silicon, for instance. The gate electrode 5 of transistor $T_1$ is covered by an insulator layer 6 of $SiO_2$ having a thickness of approximately 6000 Å, over which a write select transistor $T_2$ is formed.

The write select transistor $T_2$ overlaid on the read select transistor $T_1$ comprises a first diffusion region 9a of n+ type (drain region), a second diffusion region 9b of n+ type (source region), a gate insulator 10 of $SiO_2$ having a thickness of approximately 300 Å, a channel region Ch2 or 8 and a gate electrode 11. The silicon layer 8 of p type has a thickness of 5000 to 8000 Å, being formed using a silicon-on-insulator (SOI) technology. The first diffusion region 9a and the second diffusion region 9b are formed in the silicon layer 8. The region 9a reaches an insulator layer 7 of $SiO_2$ having a thickness of approximately 300 Å and is connected to the drain region 3a of read select transistor $T_1$ through a contact window 13a (Fig. 2 (c), see also 13 in Fig. 2 (b)).

A storage transistor $T_3$ comprises the source region 3b, a drain region Ch1 which is used commonly with the read select transistor $T_1$, the insulator layer 7 (as gate insulator), the channel region Ch3, and a gate electrode 9b which is commonly used as the source region of the write select transistor $T_2$.

Thus, the combined device comprising the read select transistor $T_1$ and the storage transistor $T_3$ can be regarded as a dual gate field effect transistor, comprising a drain region 3a, a source region 3b, a channel region Ch1 plus Ch3, two gate insulators 4,7 and two gate electrodes 5,9b. In addition, by overlaying the write select transistor $T_2$ over the read select transistor $T_1$, one of the source region and the drain region of the transistor $T_2$ is commonly used as the gate electrode of the storage transistor $T_3$. These two factors serve to increase substantially the packing density of the cell.

The gate electrode 5 of the read select transistor $T_1$ and the gate electrode 11 of the write select transistor $T_2$ are extended in a Y direction (indicated by an arrow marked Y in Fig. 2 (b)) to play the rôles of a read select line RL and a word select line WL respectively. A phospho-silicate glass layer 12 is formed to cover the transistors and lines of the device, and a data bit line DL 14 of aluminium is formed thereon in a direction perpendicular to the Y-direction, being connected to the drain regions 9a and 3a through a contact hole 13b (Fig. 2 (c), see also 13 in Fig. 2 (b)) opened in the phosphosilicate glass layer 12. The source region 3b is extended to serve as a ground line GND as shown in the plan view of Fig. 2 (b). Thus the circuit configuration shown in Fig. 2 (a) is realized.

To write a logical "O" into the cell, the data bit line DL is maintained at a high level and the write select line WL, namely the gate electrode 11 of the write select transistor $T_2$, is brought to a higher voltage level to make the write select transistor $T_2$ "ON", bringing the gate electrode 9b of the storage transistor $T_3$ to high level to keep the transistor $T_3$ in "ON" state. Thereafter, the write select transistor $T_2$ is made "OFF" to keep the voltage level of the gate electrode 9b of the storage transistor $T_3$ high, storing the logical "O".

When reading a stored logical "O" from the cell, the data bit line DL is brought to a predetermined voltage level such as an intermediate voltage $V_m$ level between high level and low level and kept floating. Thereafter, the read select transistor $T_1$ is made "ON". Since the storage transistor $T_3$ is in an "ON" state, a current flows from the data bit line DL to the ground line GND through the read select transistor $T_1$ and the storage transistor $T_3$ substantially pulling down the voltage of the data bit line DL to the ground voltage. The reduction of the voltage of the data bit line DL represents the logical "O".

For writing a logical "I" into the cell, the data bit line DL is maintained at a low voltage level, and simultaneously the write select transistor $T_2$ is made "ON", making the voltage level of the gate of the storage transistor $T_3$ low. Then, the write select transistor $T_2$ is made "OFF" thereafter, maintaining the gate voltage level of the storage transistor $T_3$ low, namely, maintaining the storage transistor $T_3$ in "OFF" state.

When reading out the logical "I" from the cell, the data bit line DL is maintained at the voltage level $V_m$, for instance, and the read select transistor $T_1$ is made "ON". Since the storage transistor $T_3$ is "OFF" state, no current flows through the circuit storage transistor $T_3$ plus read select transistor $T_1$, maintaining the voltage of the data bit line DL at $V_m$, providing no voltage difference (no pull-down of the data bit line voltage) which represents the logical "1".

As described above, the circuitry of the first embodiment of the present invention operates in the same manner as that of a previously prepared DRAM cell. However, the storage transistor $T_3$ and the read select transistor $T_1$ co-possess their channel regions Ch3 and Ch1, eliminating diffusion regions for connecting the two transistors. Furthermore, one of the source-drain regions of the write select transistor $T_2$ is commonly used as the gate electrode of the storage transistor $T_3$. As the result, a remarkable reduction in cell area can be achieved, enabling packing density to be increased significantly.

In addition, the gate electrode 9b of the storage transistor $T_3$ wherein information is stored in the form of electrical charges, is electrically isolated from the substrate 1 by the surrounding silicon dioxide layer 6 and 7, resulting in an effect which serves for preventing soft error problems, due to alpha ray irradiation.

The circuit configuration of Fig. 2 (a) can be illustrated in another configuration as shown in Fig. 2 (d), wherein the read select transistor $T_1$ and the storage transistor $T_3$ are replaced by a dual-gate electrode MOS transistor $T_d$. It will be apparent from the above description of the first embodiment of the present invention, for those skilled in the art, that both circuit configurations are entirely the same with regard to circuit operation.

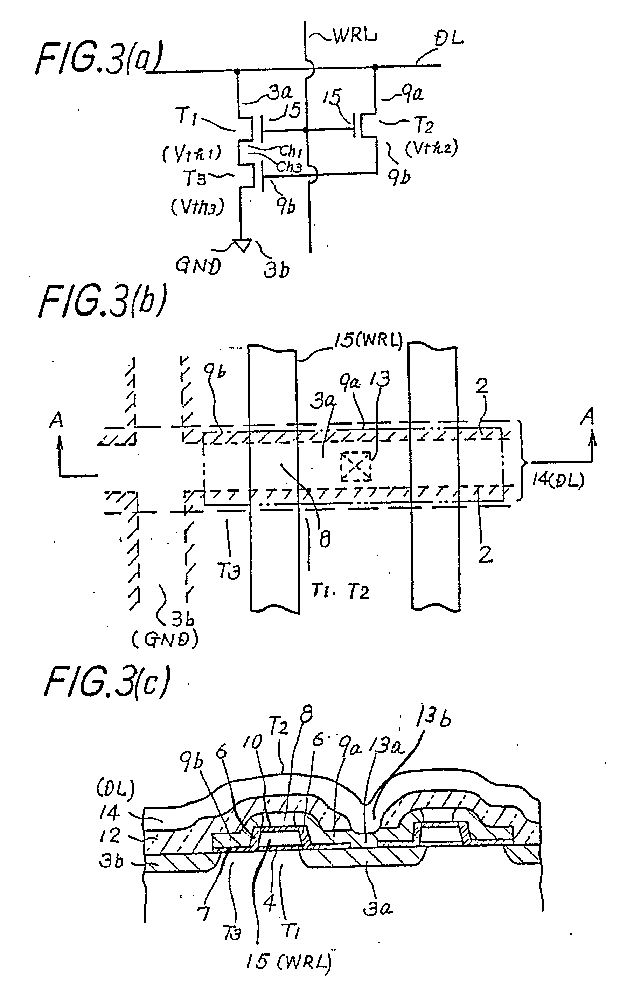

Now, a second embodiment in accordance with the present invention will be described with reference to Figs. 3 (a) to 3 (c). The memory cell of the second embodiment has three transistors and two control lines as shown in the circuit diagram of Fig. 3 (a). In comparison with the cell of Fig. 2 (a), the read select line RL and write select line WL of Fig. 2 (a) are replaced by a single line, write/read select line WRL to which the gate electrodes of a write select transistor $T_2$ and read select transistor $T_1$ are connected. Therefore, in order to distinguish these two transistors from each other, the threshold voltages of the two transistors $T_1$ and $T_2$, namely $V_{th1}$ and $V_{th2}$ respectively, are made different from each other. Thus control lines are reduced by one, and the resulting cell structure is further simplified.

Fig. 3 (b) is a partial plan view of a DRAM device, illustrating the configuration of a memory cell in accordance with the second embodiment, and Fig. 3 (c) is a cross-sectional view of the cell taken along the line A-A shown in the partial plan view of Fig. 3 (b).

Threshold voltages of transistors $T_1$, $T_2$ and $T_3$ are designated by $V_{th1}$, $V_{th2}$ and $V_{th3}$ respectively, and voltage levels of write/read select line WRL for selecting a reading or a writing operation are designated by $V_r$ and $V_w$ respectively. The voltage level of the data bit line DL, namely a data signal is designated by $V_d$.

Taking the threshold voltage of storage transistor $T_3$ as $V_{th3} = V_{th1}$, the relationships required for the above threshold voltage levels are as follows:

$V_{th1} < V_r < V_{th2}$      (read out condition)

$V_d + V_{th2} < V_w$      (write in condition)

$V_{th1} < V_d$      (readable condition).

When writing an information signal (e.g. "0" or "1") into the cell, $T_2$ is made conductive by holding the write/read select line WRL at $V_w$. Thereafter, an input signal voltage, 0 volt or $V_d$, is applied to the data bit line DL, namely, to the gate of $T_3$, depending on the input logical value to be written, resulting in an "OFF" state or an "ON" state of the storage transistor $T_3$. In this circuit configuration, the read select transistor $T_1$ is made also conductive simultaneously. When the data signal is 0 volt, no current flows through $T_1$-$T_3$ line since storage transistor $T_3$ is in an "OFF" state and no problem occurs. However, when the data signal is $V_d$, a current flows from the data bit line DL to the ground line GND, which has an adverse effect so far as holding the voltage of the data bit line DL at $V_d$ is concerned. Therefore, in order to maintain the voltage level $V_d$ of the DL line, it is necessary to make the equivalent resistance of the associated driving circuit of the data bit line DL substantially lower than that of the series resistance of the $T_1$-$T_3$ circuit.

When reading out a stored signal from the cell, the voltage of the write/read select line WRL is held at $V_r$, making read select transistor $T_1$ "ON" and write select transistor $T_2$ "OFF" due to the condition of $V_r$ as described above. Therefore, the voltage of the gate of the storage transistor $T_3$ is maintained unchanged. Thus, when the stored signal, namely, the voltage of the gate of storage transistor $T_3$ is 0 volt, no current flows from the data bit line DL to the ground line GND since $T_3$ is in "OFF" state. Accordingly, the voltage of the data bit line DL is maintained unchanged, and is output through a sense amplifier to represent an information signal "I". When the stored signal is $V_d$, making storage transistor $T_3$ conductive, charges in the data bit line DL flow to the ground line GND, resulting in a substantial fall in the voltage of the data bit line DL, which is output through the sense amplifier to represent an information signal "0".

As seen particularly in Fig. 3(c), said read select transistor ($T_1$) and said write select transistor ($T_2$) formed over said read select transistor ($T_1$) share a common gate electrode (15 - Fig. 3(c)) with each other, said common gate electrode (15) being disposed between said read select transistor ($T_1$) and said write select transistor ($T_2$) and effective for the respective transistors through respective gate insulator layers (4, 10). The side walls of the common gate electrode (15) are covered by insulating layers.

As described above in detail, two-storied structures and circuit configurations in accordance with the present invention can provide for high packing densities in associated DRAM devices. In addition, the present invention serves to provide a DRAM device with easier fabricating processes, thereby serving to reduce manufacturing costs. An example of a method of fabrication of a DRAM cell according to the first embodiment of the present invention will now be described with reference to the partial plan view of Fig. 4 and the partial cross-sectional views of Fig. 5(a) to (e), each taken along the line A-A in Fig. 4, representing the cell at respective steps or stages in its fabrication.

With reference to Fig. 4 and Fig. 5 (a):-

A p-type silicon substrate 1 is prepared, and field oxide layers FOX of silicon dioxide ($SiO_2$) are formed thereon by a conventional method, defining transistor regions $A_{cell}$, being followed by the further formation of a first gate insulator layer 4 approximately 300 Å thick over the transistor regions $A_{cell}$ by a conventional thermal oxidizing method. On the gate insulator layer 4, a tungsten silicide ($WSi_2$) layer 5 approximately 2000 Å thick and an $SiO_2$ layer 6 approximately 5000 to 8000 Å thick are formed subsequently by conventional chemical vapour deposition (CVD). The layers 5 and 6 are laminated in the mentioned order. By an ordinary patterning process, a gate electrode 5 for read select transistor $T_1$, having $SiO_2$ insulator layer 6 thereon, is formed. The gate electrode 5 is extended over the substrate and plays a rôle as a read select line RL. Then a photoresist mask R (indicated by broken lines in Fig. 5 (a))is formed to cover the area on the substrate except for predetermined regions for data bit lines. Thereafter, arsenic (As) ions are implanted into the exposed areas of the silicon substrate with a dose of $5 \times 10^{15} cm^{-2}$ and an accelerating energy of 100 KeV, this being followed by removal of the photoresist mask R and by appropriate heat processing for diffusing the implanted As dopants to form a $n^+$ type drain region 3a.

With reference to Fig. 5 (b):-

Subsequently, the exposed surface (uncovered by the patterned gate electrode 5 on the $SiO_2$ layer (the gate insulator layer 4)) is etched off by a conventional wet etching method. Then a second gate insulator layer of $SiO_2$ approximately 300 Å thick is formed by a conventional thermal oxidizing method. Hereby, on the side wall of the gate electrode 5, a rather thick $SiO_2$ layer approximately 500 Å is formed.

Thereafter, a contact window 13a is opened in the second gate insulator layer 7 over the n+ type drain region 3a, this being followed by the formation of a thick polycrystalline silicon layer 8 approximately 5000 Å thick over the entire surface of the substrate 1. The polycrystalline silicon layer is converted to a single crystal layer by irradiation with a laser beam or an electron beam having a predetermined energy for heating. This is one of the SOI (silicon on insulator) technologies and the single crystal silicon layer is referred to as an SOI layer 8 which serves to form an MOS FET having a small gate leakage current. At the next step, the SOI layer 8 is doped, to become a p-type diffusion layer with $10^{16}$ cm$^{-3}$ dopant density, by boron (B+) ion implantation and subsequent heat treatment.

There is an alternative method for forming the SOI layer 8 utilizing an SOI technology, namely solid phase epitaxy. A polycrystalline silicon layer formed on the entire substrate by a conventional CVD method may be converted into a layer of single crystal silicon structure by re-crystallization using a heat treatment at approximately 600 °C whereby the exposed single crystal structure of the contact region acts as seed for the recrystallization.

Referring to Fig. 5 (c):-

Subsequently, the SOI layer 8 and the second gate insulator layer 7 are patterned simultaneously to expose a source region including a ground region, a third gate insulator region 10 approximately 300 Å thick is formed by a thermal oxidizing method. This step is followed by a chemical vapour deposition (CVD) process to form a tungsten silicide (WSi₂) layer of approximately 2000 Å thickness, accompanied by a photolithographic process for patterning a gate electrode 11 of a write select transistor T₂. The gate electrode 11 is extended to play a rôle as a word select line WL.

Referring to Fig. 5 (d):-

The next step is ion implantation of arsenic ions (As+) with approximately 5X10$^{15}$ dose and with an accelerating energy of approximately 120 KeV over the entire substrate, followed by a predetermined heat treatment, forming a first n+ type region 9a as a drain region of write select transistor T₂, a second n+ region 9b as a source region of write select transistor T₂, and an n+ type source region 3b. The source region 3b of storage transistor T₃ is extended to act as a ground line. The above-described n+ type regions 9a and 9b are formed to reach the underlying SOI layer 8.

Referring to Fig. 5 (e):-

The entire substrate is then covered with a phosphosilicate glass layer 12 by a conventional method, and a contact window 13b is formed to expose the underlying drain region 3a of read select transistor T₁. Subsequently, by a conventional method, a data bit line DL of aluminium or other metal is formed over the phosphosilicate glass layer 12 so that the data bit line DL is connected to the drain region 9a of write select transistor T₂ and the drain region 3a of read select transistor T₁ through the contact window 13b. Finally, formation of a passivating layer for the substrate and other final processes (not shown) are performed to complete the semiconductor memory device.

As described above in detail, through all the fabricating steps of the semiconductor memory device, conventional semiconductor fabricating technologies are used, requiring no increase in the fabrication cost.

A dynamic random access memory (DRAM) cell having three MIS transistors arranged in two-storied layers having a high packing density configuration is disclosed. A write select transistor is disposed overlying a read select transistor, being electrically separated from each other through an insulator layer, and a drain region of the write select transistor is shared with the underlying read select transistor as its gate electrode. A storage transistor and the read select transistor are formed on a silicon substrate in the same level and channel regions of both transistors are connected to each other and used as a diffusion region of the opposite transistor, resulting in elimination of connecting members such as diffusion regions and a conducting path therebetween which were otherwise necessary. These two points contribute to elevate the packing density of the cell. Furthermore, a write select line and a read select line are combined into a single control line: write/read select line, saving one line to obtain higher packing density. In the cell, gate electrodes of both transistors are connected to the write/read line. These transistors are distinguished from each other by their different threshold voltage levels from each other.

**Claims**

1. A three-transistor cell for a dynamic random access memory formed on a semiconductor substrate (1), the cell comprising
   a read select transistor (T₁), having a drain (3a) connected to a data bit line (DL) of the memory, and a gate (5, 15) connected to a read select line (RL, WRL) of the memory,
   a storage transistor (T₃), having a drain (Ch1) connected to a source (Ch3) of the read select transistor (T₁) and a source (3b) connected to a ground line (GND) of the memory, and
   a write select transistor (T₂) having a source (9b) connected to a gate (9b) of the storage transistor, a gate (11, 15) connected to a write select line (WL, WRL) of the memory, and a drain (9a) connected to the data bit line (DL),
   characterised in that
   the read select transistor (T₁) and the storage transistor (T₃) are formed as a dual gate transistor (T₁, T₃; T_d), a channel region (Ch1) of the read select transistor being directly connected to a channel region (Ch3) of the storage transistor to provide a channel region (Ch2, Ch3) of the dual gate transistor, the channel region (Ch1) of the read select transistor also acting as drain of the storage transistor and the channel region (Ch3) of the storage transistor also acting as source of the read select transistor, the drain (3a) of the read select transistor being the drain of the dual gate transistor and the source (3b) of the storage transistor being the source of the dual gate transistor, between which drain (3a) and source (3b) the channel region (Ch1, Ch3) of the dual gate transistor lies, and the two gates of the dual gate transistor being, respectively, the gate (5; 15) of the read select transistor and the gate (9b) of the storage transistor, which gates overlie the channel region (Ch1, Ch3) of the dual gate transistor via an interposed insulator layer (4, 7),

and characterised in that

the write select transistor (T2) is formed over the read select transistor (T1), with an interposed insulator layer (6, 7; 6, 7, 10), the drain (9a) of the write select transistor being connected directly to the drain (3a) of the read select transistor through a window or opening in the latter interposed insulator layer,

and in that

the source region (9b) of the write select transistor (T2) acts also as the gate of the storage transistor (T3) which is otherwise provided on the same side of the latter interposed insulator layer as the read select transistor.

2. A cell as claimed in claim 1, wherein the read select transistor (T1) and the write select transistor (T2) share a common gate (15) connected to a combined read/write select line (WRL) of the memory, the read select transistor and the write select transistor having respective gate insulator layers (4, 10) and respective different threshold voltages (Vth1, Vth2).

3. A cell as claimed in claim 2, wherein said read select transistor (T1) and said write select transistor (T2) formed over said read select transistor (T1) share a common gate electrode (15-Fig. 3 (c)) with each other, said common gate electrode (15) being disposed between said read select transistor (T1) and said write select transistor (T2) and effective for the respective transistors through respective gate insulator layers (4, 10).

4. A cell as claimed in claim 1, wherein said storage transistor (T3) has a gate electrode, side walls of which are covered by insulator layers.

5. A cell as claimed in claim 2, wherein the side walls of said common gate electrode (15) are covered by insulator layers.

6. A cell as claimed in claim 1, wherein said write select transistor (T2) is formed in a semiconductor layer (8) formed on an interposed insulator layer (7) over said read select transistor (T1), which semiconductor layer is, for example, a single crystal silicon layer fabricated utilizing a silicon on insulator (SOI) technology.

**Revendications**

1. Cellule à trois transistors pour une mémoire à accès aléatoire dynamique formée sur un substrat semiconducteur (1), la cellule comprenant :

un transistor de sélection de lecture (T1) qui comporte un drain (3a) qui est connecté à une ligne de bit de données (DL) de la mémoire et une grille (5, 15) qui est connectée à une ligne de sélection de lecture (RL, WRL) de la mémoire ;

un transistor de stockage (T3) qui comporte un drain (Ch1) qui est connecté à une source (Ch3) du transistor de sélection de lecture (T1) et une source (3b) qui est connectée à une ligne de masse (GND) de la mémoire ; et

un transistor de sélection d'écriture (T2) qui comporte une source (9b) qui est connectée à une grille (9b) du transistor de stockage, une grille (11, 15) qui est connectée à une ligne de sélection d'écriture (WL, WRL) de la mémoire et un drain (9a) qui est connecté à la ligne de bit de données (DL),

caractérisée en ce que :

le transistor de sélection de lecture (T1) et le transistor de stockage (T3) sont formés comme un transistor à double grille (T1, T3 ; Td), une région de canal (Ch1) du transistor de sélection de lecture étant directement connectée à une région de canal (Ch3) du transistor de stockage pour constituer une région de canal (Ch2, Ch3) du transistor à double grille, la région de canal (Ch1) du transistor de sélection de lecture se comportant également comme le drain du transistor de stockage et la région de canal (Ch3) du transistor de stockage se comportant également comme la source du transistor de sélection de lecture, le drain (3a) du transistor de sélection de lecture étant le drain du transistor à double grille et la source (3b) du transistor de stockage étant la source du transistor à double grille, la région de canal (Ch1, Ch3) du transistor à double grille étant placée entre le drain (3a) et la source (3b) et les deux grilles du transistor à double grille étant respectivement la grille (5, 15) du transistor de sélection de lecture et la grille (9b) du transistor de stockage, ces grilles reposant sur la région de canal (Ch1, Ch3) du transistor à double grille via une couche isolante interposée (4, 7),

et caractérisée en ce que :

le transistor de sélection d'écriture (T2) est formé sur le transistor de sélection de lecture (T1) avec une couche isolante interposée (6, 7 ; 6, 7, 10), le drain (9a) du transistor de sélection d'écriture étant directement connecté au drain (3a) du transistor de sélection de lecture au travers d'une fenêtre ou ouverture ménagée dans la seconde couche isolante interposée,

et en ce que :

la région de source (9b) du transistor de sélection d'écriture (T2) se comporte également comme la grille du transistor de stockage (T3) qui est sinon prévue sur le même côté de la seconde couche isolante interposée que le transistor de sélection de lecture.

2. Cellule selon la revendication 1, dans laquelle le transistor de sélection de lecture (T1) et le transistor de sélection d'écriture (T2) partagent une grille commune (15) qui est connectée à une ligne de sélection de lecture/écriture combinées (WRL) de la mémoire, le transistor de sélection de lecture et le transistor de sélection d'écriture ayant des couches isolantes de grille respectives (4, 10) et des tensions de seuil respectives différentes (Vth1, Vth2).

3. Cellule selon la revendication 2, dans laquelle ledit transistor de sélection de lecture (T1) et ledit transistor de sélection d'écriture (T2) qui est formé au-dessus dudit transistor de sélection de lecture (T1) partagent une électrode de grille commune (15-figure 3(c)) l'un avec l'autre, ladite électrode de grille commune (15) étant placée entre ledit transistor de sélection de lecture (T1) et ledit transistor de sélection d'écriture (T2) et étant efficace pour les transistors respectifs au travers des couches isolantes de grille respectives (4, 10).

4. Cellule selon la revendication 1, dans laquelle ledit transistor de stockage (T3) comporte une électrode de grille, des parois latérales de celle-ci étant recouvertes par des couches isolantes.

5. Cellule selon la revendication 2, dans laquelle les parois latérales de ladite électrode de grille commune (15) sont recouvertes par des couches isolantes.

6. Cellule selon la revendication 1, dans laquelle ledit transistor de sélection d'écriture (T2) est formé dans une couche semiconductrice (8) formée sur une couche isolante interposée (7) au-dessus dudit transistor de sélection de lecture (T1), cette couche semiconductrice étant par exemple une couche en silicium monocristallin fabriquée en utilisant une technologie silicium-sur-isolant (SOI).

**Patentansprüche**

1. Drei-Transistor-Zelle für einen dynamischen Speicher mit wahlfreiem Zugriff, der auf einem Halbleitersubstrat (1) gebildet ist, welche Zelle umfaßt,

einen Leseauswahltransistor (T1), der ein Drain (3a) hat, das mit einer Datenbitleitung (DL) des Speichers verbunden ist, und ein Gate (5, 15), das mit einer Leseauswahlleitung (RL, WRL) des Speichers verbunden ist,

einen Speichertransistor (T3), der ein Drain (Ch1) hat, das mit einer Source (Ch3) des Leseauswahltransistors (T1) verbunden ist, und eine Source (3b), die mit einer Erdleitung (GND) des Speichers verbunden ist, und

einem Schreibauswahltransistor (T2), der eine Source (9b) hat, die mit einem Gate (9b) des Speichertransistors verbunden ist, ein Gate (11, 15), das mit einer Schreibauswahlleitung (WL, WRL) des Speichers verbunden ist, und ein Drain (9a), das mit der Datenbitleitung (DL) verbunden ist,

dadurch gekennzeichnet, daß

der Leseauswahltransistor (T1) und der Speichertransistor (T3) als ein Dual-Gate-Transistor (T1, T3; Td) gebildet sind, ein Kanalbereich (Ch1) des Leseauswahltransistors direkt mit einem Kanalbereich (Ch3) des Speichertransistors verbunden ist, um einen Kanalbereich (Ch2, Ch3) des Dual-Gate-Transistors zu bilden, der Kanalbereich (Ch1) des Leseauswahltransistors auch als Drain des Speichertransistors wirkt und der Kanalbereich (Ch3) des Speichertransistors auch als Source des Leseauswahltransistors wirkt, das Drain (3a) des Leseauswahltransistors ein Drain des Dual-Gate-Transistors ist, und die Source (3b) des Speichertransistors die Source des Dual-Gate-Transistors ist, zwischen welchem Drain (3a) und Source (3b) der Kanalbereichs (Ch1,Ch3) des Dual-Gate-Transistors liegt, und die beiden Gates des Dual-Gate-Transistors jeweils das Gate (5, 15) des Leseauswahltransistors bzw.

das Gate (9b) des Speichertransistors sind, welche Gates über den Kanalbereich (Ch1, Ch3) des Dual-Gate-Transistors liegen, über einer dazwischenliegenden Isolatorschicht (4, 7),

und dadurch gekennzeichnet, daß

der Schreibauswahltransistor $(T_2)$ über dem Leseauswahltransistor $(T_1)$ gebildet ist, mit einer dazwischenliegenden Isolatorschicht (6, 7; 6, 7, 10), das Drain (9a) des Schreibauswahltransistors direkt mit dem Drain (3a) des Leseauswahltransistors über ein Fenster oder eine Öffnung in der letztgenannten dazwischenliegenden Isolatorschicht verbunden ist,

und daß,

der Source-Bereich (9b) des Schreibauswahltransistors $(T_2)$ auch als das Gate des Speichertransistors $(T_3)$ wirkt, welches sonst auf derselben Seite der letztgenannten dazwischenliegenden Isolatorschicht als der Leseauswahltransistor vorgesehen ist.

2. Zelle nach Anspruch 1, bei der der Leseauswahltransistor $(T_1)$ und der Schreibauswahltransistor $(T_2)$ ein gemeinsames Gate (15) gleichzeitig verwenden, welches mit einer kombinierten Lese/Schreib-Auswahlleitung (WRL) des Speichers verbunden ist, wobei der Leseauswahltransistor und der Schreibauswahltransistor jeweils Gateisolatorschichten (4, 10) und entsprechend verschiedene Schwellenwertspannungen (Vth1, Vth2) haben.

3. Zelle nach Anspruch 2, bei der der genannte Leseauswahltransistor $(T_1)$ und der genannte Schreibauswahltransistor $(T_2)$, der über dem genannten Leseauswahltransistor $(T_1)$ gebildet ist, eine gemeinsame Gateelektrode (15-Fig. 3 (c)) miteinander verwenden, wobei die genannte gemeinsame Gateelektrode (15) zwischen dem genannten Leseauswahltransistor $(T_1)$ und dem genannten Schreibauswahltransistor $(T_2)$ angeordnet und für die entsprechenden Transistoren über entsprechende Gateisolatorschichten (4,10) effektiv ist.

4. Zelle nach Anspruch 1, bei der der genannte Speichertransistor $(T_3)$ eine Gateelektrode hat, deren Seitenwände mit Isolatorschichten bedeckt sind.

5. Zelle nach Anspruch 2, bei der die Seitenwände der gemeinsamen Gateelektrode (15) mith Isolatorschichten bedeckt sind.

6. Zelle nach Anspruch 1, bei der der genannte Schreibauswahltransistor (T2) in einer Halbleiterschicht (8) gebildet ist, die auf einer dazwischenliegenden Isolatorschicht (7) über dem genannten Leseauswahltransistor $(T_1)$ gebildet ist, welche Halbleiterschicht, z.B., eine einkristalline Siliciumschicht ist, die unter Verwendung einer Silicium-auf-Isolator-(SOI)-Technologie hergestellt ist.

FIG. 1

FIG. 2 (d)

11

FIG.2(a)

FIG.2(b)

FIG.2(c)

FIG.3(a)

FIG.3(b)

FIG.3(c)

FIG.4

FIG.5(a)

FIG.5(b)

FIG. 5(c)

FIG. 5(d)

FIG. 5(e)